(19) **Europäisches Patentamt**

**European Patent Office**

**Office européen des brevets**

(11) **EP 1 221 221 B1**

(12) **EUROPÄISCHE PATENTSCHRIFT**

(45) Veröffentlichungstag und Bekanntmachung des Hinweises auf die Patenterteilung:
**02.05.2003 Patentblatt 2003/18**

(51) Int Cl.7: **H04L 7/033**, H04L 25/02, H03L 7/113, H03L 7/087, H03L 7/14

(21) Anmeldenummer: **00987020.5**

(22) Anmeldetag: **24.10.2000**

(86) Internationale Anmeldenummer:
**PCT/DE00/03749**

(87) Internationale Veröffentlichungsnummer:
**WO 01/033764 (10.05.2001 Gazette 2001/19)**

(54) **TAKT- UND DATENREGENERATOR FÜR UNTERSCHIEDLICHE DATENRATEN**

CLOCK PULSE AND DATA REGENERATOR FOR DIFFERENT DATA RATES

REGENERATEUR DE RYTHME ET DE DONNEES POUR DIFFERENTS DEBITS DE DONNEES

(84) Benannte Vertragsstaaten:
**DE FR GB IT**

(30) Priorität: **29.10.1999 DE 19952197**

(43) Veröffentlichungstag der Anmeldung:
**10.07.2002 Patentblatt 2002/28**

(73) Patentinhaber: **SIEMENS AKTIENGESELLSCHAFT**
**80333 München (DE)**

(72) Erfinder:
• **STILLING, Bernd**
  **81379 München (DE)**
• **SOMMER, Jörg**
  **81379 München (DE)**

(56) Entgegenhaltungen:
EP-A- 0 844 738          WO-A-98/38744
DE-A- 19 704 299        US-A- 5 216 387
US-A- 5 512 860         US-A- 5 577 086

EP 1 221 221 B1

**Beschreibung**

Die Erfindung betrifft einen Takt- und Datenregenerator für unterschiedliche Datenraten mit einer Phasen- und Frequenzregeleinrichtung nach dem Oberbegriff des Patentanspruchs 1.

Phasenregelkreise, kurz als PLL bezeichnet, werden verwendet, um aus einem empfangenen binären Signal das Taktsignal wiederzugewinnen und mit Hilfe dieses Taktsignals ein regeneriertes Datensignal zu erhalten.

Bei einer Taktregenerationseinrichtung wählt man eine kleine Bandbreite der Regelschleife, damit die Frequenz und Phase auch im Falle einer langen Folge von Nullen oder Einsen konstant bleibt. Ein stabiler Phasenregelkreis weist jedoch einen sehr engen Fangbereich auf. Das bedeutet, daß die Taktrückgewinnung nur in einem sehr schmalen Frequenzbereich - also im wesentlichen nur für eine ganz bestimmte Bitrate - arbeitet.

In "Frequency Detectors for PLL Acquisition in Timing and Carrier Recovery" von David G. Messerschmitt, IEEE Transaction Communication, vol. COM-27, pp. 1288-1295, September 1979 ist ein Phasenregelkreis (PLL) beschrieben, der einen Phasen- und einen Frequenzdiskriminator aufweist. Mit Hilfe des Frequenzdiskriminators erfolgt zunächst eine grobe Einstellung der Oszillatorfrequenz, die Phase zwischen dem erzeugten Taktsignal und dem Datensignal wird dann über den Phasenregelkreis konstant gehalten. In der Praxis weisen diese Phasenregelkreise einen Fangbereich von ca. +/-30% der Datensignalfrequenz (Bitrate) auf.

Soll die Taktregeneration für unterschiedliche Datenraten verwendet werden, so reicht der Fangbereich der PLL häufig nicht aus.

Aus der Offenlegungsschrift DE 197 04 299 A1 ist eine Vorrichtung zur Gewinnung eines Taktsignals aus einem Datensignal mit einer Bitratenerkennungseinrichtung für das empfangenen Datensignals bekannt. Der Bitratenerkennungseinrichtung werden verschiedene Referenzsignale zugeführt, die einen Vergleich der Flankendichten des empfangenen Datensignals und der Referenzsignale ermöglichen. Das Ergebnis dieses Vergleichs wird dazu benutzt, einen Frequenzteiler im Rückkopplungsweg so einzustellen, daß die Phasenregelung erfolgreich wirksam wird. Diese Vorrichtung ist besonders für wenige empfangsseitig bekannte Bitraten geeignet.

Aufgabe der Erfindung ist es, einen Takt- und Datenregenerator anzugeben, der lückenlos bei unterschiedliche Bitraten des Datensignals zuverlässig arbeitet. Dieser soll so weitergebildet werden, daß auch unterschiedlich codierte Datensignale verarbeitet werden können.

Diese Aufgabe wird durch einen Takt- und Datenregenerator nach Anspruch 1 gelöst.

Vorteilhafte Weiterbildungen der Erfindung sind in den Unteransprüchen gegeben.

Ein besonderer Vorteil liegt in der universellen Einsetzbarkeit und des Regenerators durch seinen großen Arbeitsbereich. Ein Referenztakt ist im allgemeinen nicht erforderlich, kann jedoch verwendet werden, um eine Voreinstellung des Frequenzteilers zu ermöglichen.

Der wesentliche Vorteil wird durch einen weiteren Frequenzdiskriminator erzielt, der einen in der Rückkopplungsschleife des Regelkreises angeordneten Frequenzteiler einstellt und eine aus der Oszillatorfrequenz gewonnene Vergleichsfrequenz soweit verstellt, daß sie in den Fangbereich des ersten Frequenzdiskriminators gelangt.

Bei einer einfacheren Ausführung wird der Frequenzteiler schrittweise verstellt, während bei schneller arbeitenden Ausführungen aufgrund der Meßergebnisse des weiteren Frequenzdiskriminators der Teiler direkt voreingestellt werden kann. Beide Frequenzdiskriminatoren können selbstverständlich schaltungsmäßig zusammengefaßt werden.

Die Erfindung wird anhand von Ausführungsbeispielen näher erläutert.

Figur 1    zeigt den erfindungsgemäßen Takt- und Datenregenerators,

Figur 2    zeigt eine Variante des Takt- und Datenregenerators,

Figur 3    zeigt ein Ausführungsbeispiel des zweiten Frequenzdiskriminators und

Figur 4    zeigt Steuerkennlinien der Diskriminatoren.

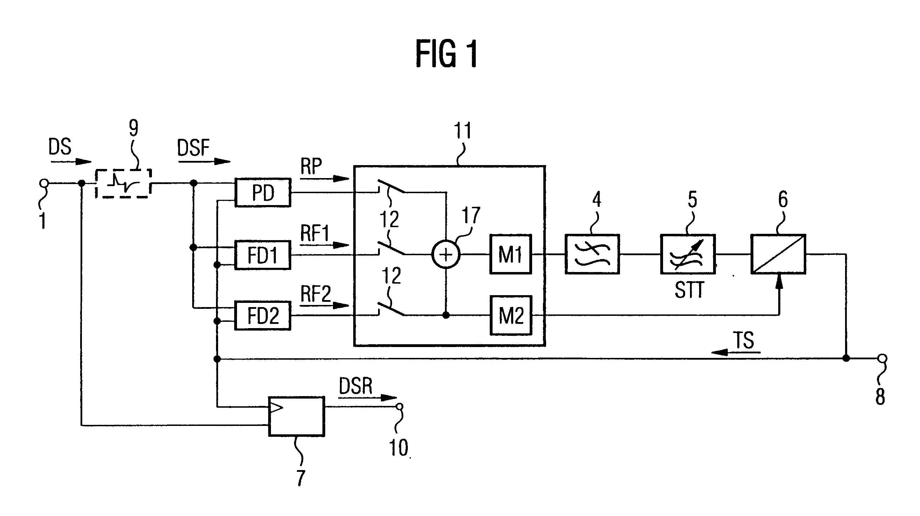

**Figur 1** zeigt das Prinzipschaltbild des erfindungsgemäßen Regenerators, der eine Frequenzregelung und eine Phasenregelung aufweist. Der Phasenregelkreis (PLL) wird aus einem Phasendiskriminator PD, einem Schleifenfilter (Loop-Filter), einem steuerbaren Oszillator 5 und einem Frequenzteiler 6 gebildet, der ein Taktsignal TS erzeugt, das auf einen zweiten Eingang des Phasendiskriminators PD rückgekoppelt ist. Als Referenzsignal wird das Datensignal DSF verwendet. Dies kann das am Signaleingang 1 empfangene Datensignal DS oder ein aus diesem Signal in einer Signalaufbereitung 9 abgeleitetes Datensignal DSF sein. Die Signalaufbereitung setzt jede Flanke des Datensignals beispielsweise in eine positive Flanke um. Dies kann dann zweckmäßig sein, wenn das empfangene Datensignal ein NRZ-Signal (non return to zero) ist und nicht die gewünschte Grundwelle aufweist.

Die Frequenzregelung erfolgt jeweils mit Hilfe eines ersten Frequenzdiskriminators FD1 und eines zweiten Frequenzdiskriminators FD2, denen das am Ausgang des Frequenzteilers abgegebene Taktsignals TS ebenfalls zugeführt wird. Das empfangene Datensignal wird außerdem einem Entscheider 7 zugeführt, der es mit dem Taktsignal abtastet und als regeneriertes Datensignal DSR am Datenausgang 10 abgibt. Das Taktsignal steht an einem Taktsignalausgang 8 zur Verfügung.

Außerdem ist eine Steuerung 11 vorgesehen, die eine Neusynchronisierung steuert. Über sie wird der Frequenzteiler 6 so umgeschaltet, daß die Sollfrequenz des Taktsignals durch den Ziehbereich des steuerbaren Oszillators erreicht werden kann

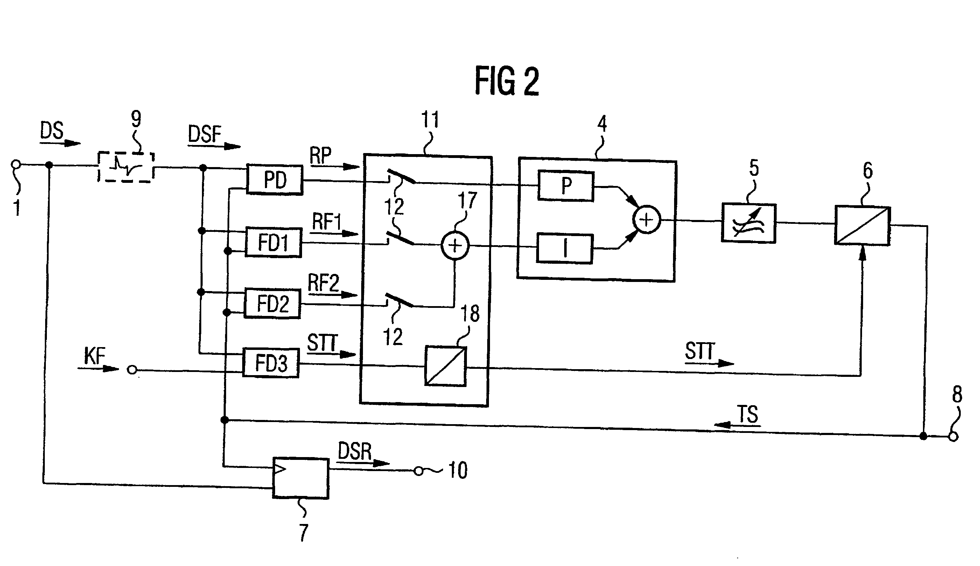

Die Funktion des Takt- und Datenregenerators soll jedoch zunächst anhand einer in **Figur 2** dargestellten Variante erläutert werden. Diese weist einen dritten Frequenzdiskriminator FD3 auf, dem ein externes Referenzsignal KF zugeführt wird. Der Frequenzdiskriminator FD3 zählt separat die Anzahl der Flanken des Datensignals DS und die des Referenzsignals KF innerhalb eines vorgegebenen Zeitraumes. Zweckmäßig ist es, wenn vorher die Oszillatorfrequenz etwa in die Mitte des Ziehbereichs gestellt worden ist. Die Steuerung ermittelt aus den Flankendichten die Bitrate des Datensignals und stellt zunächst bei dem Frequenzteiler 6 ein Teilverhältnis ein, bei dem der zweite Frequenzdiskriminator FD2 die Sollfrequenz des Oszillators zumindest grob einstellen kann. Der zweite Frequenzdiskriminator FD2 liefert, da nach der Frequenzteilereinstellung in der Regel noch größere Frequenzunterschiede zwischen Referenzsignal und Taktsignal bestehen, ein Regelsignal RF2 an das Schleifenfilter 4, das für eine weitere Angleichung sorgt. Dieser Frequenzdiskriminator hat den Vorteil eines sehr großen Arbeitsbereiches; er kann aber bei einem unbekannten Übertragungscodes und damit bei unbekannter Auftrittswahrscheinlichkeit für eine Datenflanke eine unzureichende Genauigkeit aufweisen. Da er sein Regelsignal auf dieselbe Weise ermittelt wie der dritte Frequenzdiskriminator FD3 die Bitrate des Datensignals, kann er auch dessen Aufgabe mit übernehmen.

Die Frequenzdiskriminatoren FD3, FD2 sorgen dafür, daß der Takt- und Datenregenerator bei den unterschiedlichsten Bitraten des Datensignals zuverlässig arbeiten kann.

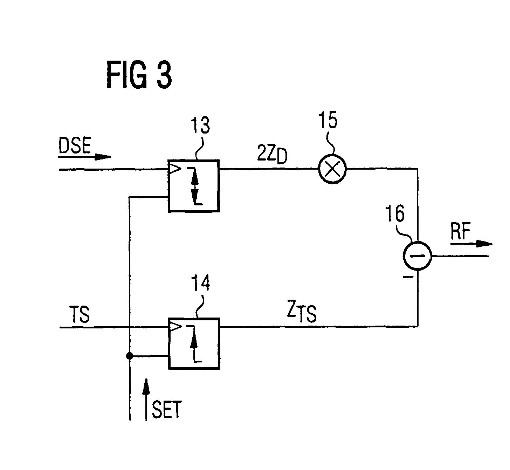

Die Funktion des zweiten bzw. dritten Frequenzdiskriminators soll nun genauer erläutert werden. In **Figur 3** ist das Blockschaltbild dargestellt. Es enthält einen ersten Zähler 13, dessen Takteingang die Datensignalflanken (jeweils ein Impuls je positiver und negativer Flanke eines NRZ-Signals) zugeführt werden und einen zweiten Zähler 14, der jeweils bei einer positiven Flanke des Taktsignals TS zählt (diesen Zählern können auch weitere Zähler vorgeschaltet sein, so daß nur jede n-te Flanke gezählt wird). Am Ende einer Zählperiode werden die Ergebnisse in einem Subtrahierer 16 voneinander subtrahiert um ein vom Frequenzunterschied $\Delta B$ abhängiges Regelkriterium zu erhalten. Anschließend werden die Zähler durch einen Setzimpuls SET zurückgestellt. Ein Multiplizierer 15 ( der einem der Zähler nachgeschaltet ist, kann als Korrekturglied das Zählergebnis des Signalflankenzählers geringfügig korrigieren. Bei stochastischen NRZ-Daten beträgt die Auftrittswahrscheinlichkeit für eine Datenflanke 0,5 je Bit. Durch Differenzbildung der Zählwerte der Datenflanken und der positiven Taktflanken kann vom zweiten Frequenzdiskriminator ein Regelkriterium $RF2 = 2Z_D - Z_{TS}$ gewonnen werden.

Ebenfalls unter der Voraussetzung, daß die Auftrittswahrscheinlichkeit einer Datenflanke 0,5 beträgt, ergibt sich die Bitrate $B_s = \dfrac{2Z_n}{T}$, wobei T die Meßzeit ist.

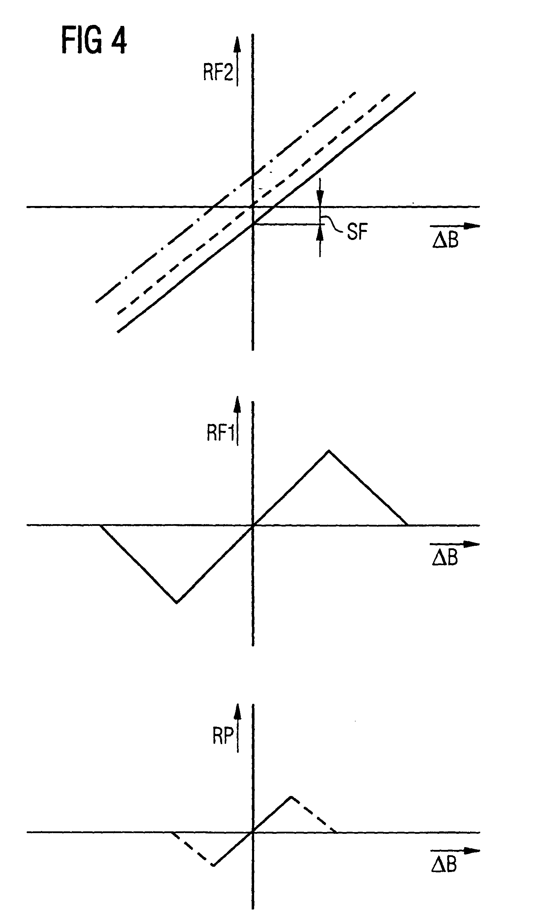

Der Meßfehler ist hierbei von der Anzahl der gemessenen Bits, bzw. der Meßzeit abhängig. Außerdem ist die Auftrittswahrscheinlichkeit für eine Datenflanke nur bei stochastischen NRZ-codierten Daten exakt 0,5. Bei den üblichen Übertragungscodes liegt der Erwartungswert für das Auftreten eines Schrittumschlags jedoch zwischen 0,5 und 0,625 beim CMI-Code je Bit, so daß es einen vom Code abhängigen systematischen Meßfehler SF geben kann. In **Figur 4**, oben sind Kennlinien für verschiedene Codes eingezeichnet. Bei der durchgezogenen Kennlinie ist der systematische Meßfehler SF des Regelsignals eingezeichnet. Geht man von einem mittleren Erwartungswert von 0,5625 aus, dann liegt der Fehler etwas über 10%. Es verbleibt bei der Frequenzregelung durch den zweiten Frequenzdiskriminator also genügend Sicherheit, um den Fangbereich von +/-30% der Datenrate des ersten Frequenzdiskriminators zu erreichen. Entsprechendes gilt für die Teilereinstellung durch den dritten Frequenzdiskriminator.

Von der Steuerung 11 kann das Zählergebnis aufgrund einer gespeicherten Tabelle 18 zur Einstellung des Frequenzteilers der Regelschleife verwendet werden.

Für den zweiten und dritten Frequenzdiskriminator sind natürlich auch andere Ausführungsformen, auch analoge möglich.

Der Ziehbereich des Oszillators und die Einstellstufen des Frequenzteilers müssen aufeinander abgestimmt sein. Die Oszillatorfrequenz muß sich stets soweit verändern lassen, daß der zweite Frequenzdiskriminator FD2 zur groben Frequenzregelung ausreicht, bis anschließend der erste Frequenzdiskriminator FD1 die Frequenz-Feineinstellung übernehmen kann. Ist der Oszillator über beispielsweise eine Oktave durchstimmbar, so kann ein in binären Stufen umschaltbarer Frequenzteiler eingesetzt werden. Es ist eine Frage der Ausführungsform und Dimensionierung, ob die Ausgangssignale der Frequenzdiskriminatoren abgeschaltet werden.

Nach der Frequenz-Grobeinstellung durch das Frequenz-Regelsignal RF2 liefert der erste Frequenzdiskriminator FD1 ein Regelsignal RF1 für eine weitere Annäherung der Frequenzen von Datensignal und Taktsignal bis der Fangbereich des Phasendiskriminators PD erreicht ist. Der erste Frequenzdiskriminator FD1 führt hierzu einen Vergleich zwischen Referenzsignal (Datensignal) und dem vom Oszillator abgeleiteten Vergleichssignal, dem Taktsignal TS, durch und gibt üblicherweise eine dem Frequenzunterschied $\Delta B$ proportionale Frequenz-Regelspannung RF1 ab.

Ist die Schleife phasenstarr eingerastet, so ist es zweckmäßig, die Frequenzdiskriminatoren (in Figuren 1 und 2 über eine Schalteinrichtung 12) abzuschalten, da sonst der Phasenjitter, der sich ebenfalls als Frequenzänderung bemerkbar macht, über das Schleifenfilter zusätzliche Steuersignale an den Oszillator liefern würde. Statt einer Abschaltung der Regelsignale kann auch eine geeignete Ausführung der Frequenzdiskriminatoren für den gleichen Effekt sorgen.

Um eine optimales Regelverhalten zu erreichen ist es bei der Ausführung der PLL zweckmäßig, daß das Schleifenfilter einen Proportionalpfad P für den Phasendiskriminator und mindestens einen Integralpfad I für die Frequenzdiskriminatoren aufweist, deren Ausgangssignale durch einen Addierer 17 zusammengefaßt werden. Um die bei der Datenübertragung erforderlichen Stabilitätsbedingungen zu erfüllen, können die Filterparameter in Abhängigkeit von der Datenrate umgeschaltet werden.

Die Steuerung 11 kann mit einem Gedächtnis M1, M2 ausgestattet sein, die die Einstellung der PLL bei Ausfall des Datensignals konstant hält, so daß eine Neusynchronisierung sehr rasch erfolgt.

Anhand von **Figur 4** wird die Wirkungsweise des Regelung nochmals anhand der Regelsignale verdeutlicht. Bei großen Abweichungen der Bitrate regelt zuerst das Frequenz-Regelsignal $RF2 = Z_D - Z_{TS}$ des zweiten Frequenzdiskriminators FD2 - als Funktion der Differenz $\Delta B$ der Bitraten zwischen Daten- und Taktsignal - die Frequenz des Oszillators nach, bis der Fangbereich des ersten Frequenzdiskriminator FD1 erreicht wird. Die Amplitude wird hier zu Null, bzw. das Frequenz-Regelsignal RF2 wird abgeschaltet. Dann sorgt das Frequenz-Regelsignal RF1 des ersten Frequenzdiskriminator FD1 für eine genaue Anpassung der Frequenzen, bis die Phasenregelung durch das Phasen-Regelsignal RP des Phasendiskriminators PD erfolgt.

Bei den vorangegangenen Betrachtungen wurde von einer objektiven Messung der Bitrate mit Hilfe eines konstanten Referenzsignals ausgegangen. Dies ist jedoch nicht erforderlich. Vielmehr ist es entsprechend **Figur 1** auch möglich, den einen Ausgangstakt des Frequenzteilers 6, hier das Taktsignal, TS als Referenzsignal zu verwenden. Der zweite Frequenzdiskriminator FD2 vergleicht dann das Taktsignal mit dem Digitalsignal DSF und gibt wieder das Regelsignal an die Steuerung 11 weiter. Diese kennt die jetzige Teilereinstellung und diejenige, die die Funktion der Regelschleife bei der Bitrate des anliegenden Datensignals ermöglicht. Sie kann daher ebenfalls den Frequenzteiler direkt einstellen.

Die Frequenzteiler-Einstellung kann auch sukzessive erfolgen. Hierzu wird das vom zweiten Frequenzdiskriminator ermittelte Regelsignal überprüft. In Abhängigkeit von einem positiven oder negativen Ergebnis, das über einen Schwellwert hinaus geht, wird die Einstellung des Frequenzteilers 6 schrittweise verändert. Als gleichwertige Meßgröße kann natürlich auch das Steuersignal des Oszillators 5 herangezogen werden. Dies kann auch bei den zunächst beschriebenen Ausführungsformen verwendet werden, um im Regelgrenzbereich den Frequenzteilers 6 zu verstellen, so daß die Arbeitsfrequenz des Oszillators weit von der Grenze entfernt liegt, beispielsweise etwa in die Mitte des Ziehbereichs verlegt wird. Ein solcher Grenzfall kann vorliegen, wenn aufgrund des systematischen Fehlers das Teilungsverhältnis des Frequenzteilers ungünstig eingestellt wurde.

## Patentansprüche

1. Takt- und Datenregenerator für unterschiedliche Datenraten mit einem Phasendiskriminator (PD) und einem ersten Frequenzdiskriminator (FD1), denen ein Datensignal (DSF) als Referenzsignal zugeführt wird, einem Schleifenfilter (4), über das ein Oszillator (5) angesteuert wird, und einem Frequenzteiler (6) im Rückkopplungsweg, dessen Ausgangssignal als Vergleichssignal (TS) dem Phasendiskriminator (PD) und dem ersten Frequenzdiskriminator (FD1) zugeführt wird,
   **dadurch gekennzeichnet,**
   **daß** mindestens ein zweiter Frequenzdiskriminator (FD2) vorgesehen ist, der die Bitrate des Datensignals (DSF) mit der des Ausgangssignals (TS) des Frequenzteilers (6) vergleicht, und
   **daß** das Vergleichsergebnis das Teilungsverhältnis des Frequenzteilers (5) bestimmt und ein Regelsignal (RF2) liefert, das gefiltert den Oszillator (5) steuert.

2. Takt- und Datenregenerator nach Anspruch 1,
   **dadurch gekennzeichnet,**
   **daß** aufgrund des Vergleichsergebnisses des zweiten Frequenzdiskriminators (FD2) das Teilungsverhältnis des Frequenzteilers (6) gegebenenfalls verringert oder vergrößert wird.

3. Takt- und Datenregenerator nach Anspruch 1,
   **dadurch gekennzeichnet,**
   **daß** aufgrund des Vergleichsergebnisses des zweiten Frequenzdiskriminators (FD2) das Teilungsverhältnis des Frequenzteilers (6) eingestellt wird.

4. Takt- und Datenregenerator nach einem der vorhergehenden Ansprüche,
   **dadurch gekennzeichnet,**
   **daß** eine Steuerung (11) vorgesehen ist, die das Vergleichsergebnis des zweiten Frequenzdiskriminators (FD2) in ein Steuersignal (STT) umsetzt, das das Teilungsverhältnis des Frequenzteilers (5) bestimmt und außerdem das Vergleichsergebnis in ein zweites Regelsignal (RF2) umsetzt, das gefiltert den Oszillator (5) steuert.

5. Takt- und Datenregenerator nach Anspruch 1,

**dadurch gekennzeichnet,**
**daß** ein dritter Frequenzdiskriminator (FD3) vorgesehen ist, dem zum Ermitteln der Bitrate des Datensignals (DS$_F$) ein konstantes Referenzsignal (KF) zugeführt wird und dessen Ausgangssignal in ein Steuersignal (STT) umgesetzt wird, das das Teilungsverhältnis des Frequenzteilers (5) bestimmt.

6. Takt- und Datenregenerator nach Anspruch 5,
   daß eine Steuerung (11) vorgesehen ist, die das Vergleichsergebnis des dritten Frequenzdiskriminators (FD3) in ein Steuersignal (STT) umsetzt, das das Teilungsverhältnis des Frequenzteilers (5) festlegt,
   und außerdem das Vergleichsergebnis des zweiten Frequenzdiskriminators (FD2) in ein zweites Regelsignal (RF2) umsetzt, das gefiltert den Oszillator (6) steuert.

7. Takt- und Datenregenerator nach einem der Ansprüche 1 bis 3,
   **dadurch gekennzeichnet,**
   **daß** dem zweiten Frequenzdiskriminator (FD2) zur Ermittlung der Werte zur Einstellung des Frequenzteilers (6) zeitweilig das Referenzsignal (KF) zugeführt wird.

8. Takt- und Datenregenerator nach einem der vorhergehenden Ansprüche,
   **dadurch gekennzeichnet,**
   **daß** der zweite Frequenzdiskriminator (FD2) und der dritte Frequenzdiskriminator (FD3) die Schrittumschläge des Datensignals (DS$_F$) bewerten im Vergleich mit den Schrittumschlägen des Taktsignals (TS), des Referenzsignals (KF) oder der Zeit bewerten, um hieraus das Regelsignal (RF2) bzw. das Einstellsignal (STT) zu ermitteln.

9. Takt- und Datenregenerator nach einem der vorhergehenden Ansprüche,
   **dadurch gekennzeichnet,**
   **daß** der Frequenzdiskriminator (FD2, FD3) ein Korrekturglied (15) aufweist, durch das die gemessene Datenrate des Datensignals (DS) korrigiert wird.

10. Takt- und Datenregenerator nach einem der vorhergehenden Ansprüche,
    **dadurch gekennzeichnet,**
    **daß** die Frequenzdiskriminatoren (FD1, FD2) im Bereich der Sollage kein Regelsignal (RF2, RF3) abgeben oder daß ihre Regelsignale abgeschaltet werden.

11. Takt- und Datenregenerator nach einem der vorhergehenden Ansprüche,
    **dadurch gekennzeichnet,**
    **daß** Mittel zum Einstellen des Oszillators (6) auf eine mittlere Frequenz innerhalb seines Ziehbereichs bei einer Neusynchronisierung vorgesehen wird.

12. Takt- und Datenregenerator nach einem der vorhergehenden Ansprüche,
    **dadurch gekennzeichnet,**
    **daß** ein Schleifenfilter (4) für alle Diskriminatoren vorgesehen ist und als Integrator oder als Filter mit Integralanteil ausgebildet ist.

13. Takt- und Datenregenerator nach einem der vorhergehenden Ansprüche,
    **dadurch gekennzeichnet,**
    **daß** ein binär verstellbarer Frequenzteiler vorgesehen ist, und
    **daß** der ein Oszillator (5) mit einem Ziehbereich von mindestens einer Oktave vorgesehen ist.

14. Takt- und Datenregenerator nach einem der vorhergehenden Ansprüche,
    **dadurch gekennzeichnet,**
    **daß** Mittel zur Speicherung der Einstellwerte des Frequenzteilers und/oder der Oszillators(6) vorgesehen sind, die bei einer Neusynchronisierung als Startwerte verwendet werden.

15. Takt- und Datenregenerator nach einem der vorhergehenden Ansprüche,
    **dadurch gekennzeichnet,**
    **daß** das Schleifenfilter (5) einen Proportionalitätspfad (P) aufweist, dem das Regelsignal (RP) des Phasendiskriminators (PD) zugeführt wird, und mindestens einen Integralpfad (I) aufweist, dem das Regelsignal (RF1, RF2) eines der Frequenzkriminatoren (FD1, FD2) zugeführt wird.

16. Takt- und Datenregenerator nach einem der vorhergehenden Ansprüche,
    **dadurch gekennzeichnet,**
    **daß** die Filterparameter des Schleifenfilter (5) in Abhängigkeit von der Datenrate eingestellt werden.

17. Takt- und Datenregenerator nach einem der vorhergehenden Ansprüche,
    **dadurch gekennzeichnet,**
    **daß** Mittel vorgesehen sind, durch die eine Einstellung des Frequenzteilers (6)korrigiert wird, wenn der Ziehbereich des Oszillators einen Grenzwert erreicht.

18. Takt- und Datenregenerator nach einem der vorhergehenden Ansprüche,
    **dadurch gekennzeichnet,**
    **daß** eine Signalaufbereitung (9) vorgesehen ist, die das empfangene Datensignal (DS) in ein aus diesem abgeleitetes Datensignal (DSF) umsetzt, das die Grundfrequenz der Datenrate aufweist.

**Claims**

1.  Clock and data regenerator for different data rates having a phase discriminator (PD) and a first frequency discriminator (FD1), to which a data signal (DSF) is supplied as a reference signal, having a loop filter (4) via which an oscillator (5) is driven, and having a frequency divider (6) in the feedback path, whose output signal is supplied as a comparison signal (TS) to the phase discriminator (PD) and to the first frequency discriminator (FD1),
    **characterized**
    **in that** at least one second frequency discriminator (FD2) is provided, which compares the bit rate of the data signal (DSF) with that of the output signal (TS) from the frequency divider (6), and
    **in that** the comparison result governs the division ratio of the frequency divider (5) and supplies a control signal (RS2) which, filtered, controls the oscillator (5).

2.  Clock and data regenerator according to Claim 1,
    **characterized**
    **in that** the division ratio of the frequency divider (6) is reduced or increased as necessary on the basis of the comparison result of the second frequency discriminator (FD2).

3.  Clock and data regenerator according to Claim 1,
    **characterized**
    **in that** the division ratio of the frequency divider (6) is set on the basis of the comparison result of the second frequency discriminator (FD2).

4.  Clock and data regenerator according to one of the preceding claims,
    **characterized**
    **in that** a controller (11) is provided, which converts the comparison result of the second frequency discriminator (FD2) to a control signal (STT) which governs the division ratio of the frequency divider (5), and also converts the comparison result to a second control signal (RF2) which, filtered, controls the oscillator (5).

5.  Clock and data regenerator as claimed in Claim 1,
    **characterized**
    **in that** a second frequency discriminator (FD2) is provided, which compares the bit rate of the data signal (DS$_F$) with that of the output signal (TS) from the frequency divider (6),
    with the comparison result being converted to a second control signal (RF2) which, filtered, controls the oscillator (5), and
    **in that** a third frequency discriminator (FD3) is provided, to which a constant reference signal (KF) is supplied in order to determine the bit rate of the data signal (DS$_F$), and whose output signal is converted to a control signal (STT), which governs the division ratio of the frequency divider (5).

6.  Clock and data regenerator as claimed in Claim 5,
    **characterized**
    **in that** a controller (11) is provided, which converts the comparison result of the third frequency discriminator (FD3) to a control signal (STT) which governs the division ratio of the frequency divider (5),
    and, furthermore, converts the comparison result of the second frequency discriminator (FD2) to a second control signal (RF2) which, filtered, controls the oscillator (6).

7.  Clock and data regenerator according to one of Claims 1 to 3,
    **characterized**
    **in that**, in order to determine the values for setting the frequency divider (6), the reference signal (KF) is supplied to the second frequency discriminator (FD2) at times.

8.  Clock and data regenerator according to one of the preceding claims,
    **characterized**
    **in that** the second frequency discriminator (FD2) and the third frequency discriminator (FD3) assess the step changeovers of the data signal (DS$_F$) in comparison to the step changeovers of the clock signal (TS), of the reference signal (KF) or of the time, in order to use this to determine the control signal (RF2) or the setting signal (STT).

9.  Clock and data regenerator according to one of the preceding claims,
    **characterized**
    **in that** the frequency discriminator (FD2, FD3) has a correction element (15), which is used to correct the measured data rate of the data signal (DS).

10. Clock and data regenerator according to one of the preceding claims,
    **characterized**
    **in that** the frequency discriminators (FD1, FD2) do not emit any control signal (RF2, RF3) in the region of the nominal position, or in that their control signals are switched off.

11. Clock and data regenerator according to one of the preceding claims,
    **characterized**
    **in that** means are provided for setting the oscillator (6) to a mid-frequency within its pull-in range, for resynchronization.

12. Clock and data regenerator according to one of the preceding claims,
    **characterized**

**in that** a loop filter (4) is provided for all the discriminators, and is in the form of an integrator or a filter with an integral component.

13. Clock and data regenerator according to one of the preceding claims,
**characterized**
**in that** a binary-adjustable frequency divider is provided, and
**in that** the first oscillator (5) is provided with a pull-in range of at least one octave.

14. Clock and data regenerator according to one of the preceding claims,
**characterized**
**in that** means are provided for storing the setting values of the frequency divider and/or of the oscillators (6), and these setting values are used as start values for resynchronization.

15. Clock and data regenerator according to one of the preceding claims,
**characterized**
**in that** the loop filter (5) has a proportionality path (P), to which the control signal (RP) of the phase discriminator (PD) is supplied, and has at least one integral path (I), to which the control signal (RF1, RF2) of one of the frequency discriminators (FD1, FD2) is supplied.

16. Clock and data regenerator according to one of the preceding claims,
**characterized**
**in that** the filter parameters for the loop filter (5) are set as a function of the data rate.

17. Clock and data regenerator according to one of the preceding claims,
**characterized**
**in that** means are provided for correcting the setting of the frequency divider (6) when the pull-in range of the oscillator reaches a limit value.

18. Clock and data regenerator according to one of the preceding claims,
**characterized**
**in that** signal conditioning (9) is provided, which converts the received data signal (DS) to a data signal (DSF) which is derived from it and is of the fundamental frequency of the data rate.

## Revendications

1. Régénérateur de cadence d'horloge et de données pour différents débits de données comprenant un discriminateur de phase (PD) et un premier discriminateur de fréquence (FD1), auxquels est appliqué un signal de données (DSF) en tant que signal de référence, un filtre de boucle (4), par l'intermédiaire duquel un oscillateur (5) est contrôlé, et un diviseur de fréquence (6) dans la boucle de contre-réaction, dont le signal de sortie est appliqué, en tant que signal de comparaison (TS), au discriminateur de phase (PD) et au premier discriminateur de fréquence (FD1),
**caractérisé par le fait**
**qu'**il est prévu au moins un deuxième discriminateur de fréquence (FD2), qui compare le débit binaire du signal de données (DSF) à celui du signal de sortie (TS) du diviseur de fréquence (6) et
**que** le résultat de la comparaison détermine le rapport de division du diviseur de fréquence (5) et délivre un signal de régulation (RF2), qui, filtré, commande l'oscillateur (5).

2. Régénérateur de cadence d'horloge et de données selon la revendication 1
**caractérisé par le fait**
**que**, en raison du résultat de la comparaison du deuxième discriminateur de fréquence (FD2), le rapport de division du diviseur de fréquence (6) est, le cas échéant, diminué ou augmenté.

3. Régénérateur de cadence d'horloge et de données selon la revendication 1
**caractérisé par le fait**
**que**, en raison du résultat de la comparaison du deuxième discriminateur de fréquence (FD2), le rapport de division du diviseur de fréquence (6) est réglé.

4. Régénérateur de cadence d'horloge et de données selon l'une des revendications précédentes
**caractérisé par le fait**
**qu'**il est prévu une commande (11), qui convertit le résultat de la comparaison du deuxième discriminateur de fréquence (FD2) en un signal de commande (STT), lequel détermine le rapport de division du diviseur de fréquence (5) et, en outre, convertit le résultat de la comparaison en un deuxième signal de régulation (RF2), qui, filtré, commande l'oscillateur (5).

5. Régénérateur de cadence d'horloge et de données selon la revendication 1
**caractérisé par le fait**
**qu'**il est prévu un troisième discriminateur de fréquence (FD3), auquel est appliqué, pour la détermination du débit binaire du signal de données (DS$_F$), un signal de référence constant (KF) et dont le signal de sortie est converti en un signal de commande (STT), lequel détermine le rapport de division du diviseur de fréquence (5).

6. Régénérateur de cadence d'horloge et de données selon la revendication 5
**caractérisé par le fait**
**qu'**il est prévu une commande (11), qui convertit le résultat de la comparaison du troisième discriminateur de fréquence (FD3) en un signal de commande (STT), lequel détermine le rapport de division du diviseur de fréquence (5),
et, en outre, convertit le résultat de la comparaison du deuxième discriminateur de fréquence (FD2) en un deuxième signal de régulation (RF2), qui, filtré, commande l'oscillateur (6).

7. Régénérateur de cadence d'horloge et de données selon l'une des revendications 1 à 3
**caractérisé par le fait**
**que**, pour la détermination des valeurs destinées au réglage du diviseur de fréquence (6), le signal de référence (KF) est appliqué par intermittence au deuxième discriminateur de fréquence (FD2).

8. Régénérateur de cadence d'horloge et de données selon l'une des revendications précédentes
**caractérisé par le fait**
**que** le deuxième discriminateur de fréquence (FD2) et le troisième discriminateur de fréquence (FD3) évaluent les transitions de pas du signal de données ($DS_F$) par rapport aux transitions de pas du signal d'horloge (TS), du signal de référence (KF) ou du temps pour déterminer, à partir de là, le signal de régulation (RF2) ou le signal de réglage (STT).

9. Régénérateur de cadence d'horloge et de données selon l'une des revendications précédentes
**caractérisé par le fait**
**que** le discriminateur de fréquence (FD2, FD3) comporte un élément correcteur (15) par lequel le débit de données mesuré du signal de données (DS) est corrigé.

10. Régénérateur de cadence d'horloge et de données selon l'une des revendications précédentes
**caractérisé par le fait**
**que** les discriminateurs de fréquence (FD1, FD2) ne délivrent pas de signal de régulation (RF2, RF3) dans la plage de la situation de consigne ou que leurs signaux de régulation sont déconnectés dans la plage de la situation de consigne.

11. Régénérateur de cadence d'horloge et de données selon l'une des revendications précédentes
**caractérisé par le fait**
**qu'**il est prévu des moyens destinés au réglage de l'oscillateur (6), en cas de nouvelle synchronisation, sur une fréquence moyenne à l'intérieur de la plage d'entraînement.

12. Régénérateur de cadence d'horloge et de données selon l'une des revendications précédentes **caractérisé par le fait**
**qu'**il est prévu un filtre de boucle (4) pour tous les discriminateurs et qu'il est conçu sous la forme d'un intégrateur ou de filtre avec composante d'intégration.

13. Régénérateur de cadence d'horloge et de données selon l'une des revendications précédentes
**caractérisé par le fait**
**qu'**il est prévu un diviseur de fréquence réglable binairement et
**qu'**il est prévu un oscillateur (5) ayant une plage d'entraînement d'au moins une octave.

14. Régénérateur de cadence d'horloge et de données selon l'une des revendications précédentes
**caractérisé par le fait**
**qu'**il est prévu des moyens pour la mémorisation des valeurs de réglage du diviseur de fréquence et/ou de l'oscillateur (6), qui sont utilisées comme valeurs de départ en cas de nouvelle synchronisation.

15. Régénérateur de cadence d'horloge et de données selon l'une des revendications précédentes
**caractérisé par le fait**
**que** le filtre de boucle (5) comporte un circuit de proportionnalité (P), auquel est appliqué le signal de régulation (RP) du discriminateur de phase (PD), et, au moins, un circuit d'intégration (I), auquel est appliqué le signal de régulation (RF1, RF2) de l'un des discriminateurs de fréquence (FD1, FD2).

16. Régénérateur de cadence d'horloge et de données selon l'une des revendications précédentes
**caractérisé par le fait**
**que** les paramètres du filtre de boucle (5) sont réglés en fonction du débit de données.

17. Régénérateur de cadence d'horloge et de données selon l'une des revendications précédentes
**caractérisé par le fait**
**qu'**il est prévu des moyens grâce auxquels un réglage du diviseur de fréquence (6) est corrigé, lorsque la plage d'entraînement de l'oscillateur atteint une valeur limite.

18. Régénérateur de cadence d'horloge et de données selon l'une des revendications précédentes
**caractérisé par le fait**
**qu'**il est prévu un dispositif de traitement de signaux (9), qui convertit le signal de données reçu (DS) en un signal de données (DSF), qui en est déduit et qui renferme l'onde fondamentale du débit de données.

FIG 1

# FIG 2

EP 1 221 221 B1

# FIG 3

FIG 4